# EUROPÄISCHE PATENTSCHRIFT

(11) **EP 2 406 107 B1**
(45) Veröffentlichungstag und Bekanntmachung des Hinweises auf die Patenterteilung: **15.05.2013**
(21) Anmeldenummer: 10709716.4
(22) Anmeldetag: 11.03.2010
(51) Int. Cl.: B60R 11/02

(54) **EINBAURAHMEN ZUR AUFNAHME EINES GERÄTS IN EINER EINBAUÖFFNUNG**
FRAME FOR RECEIVING A DEVICE IN AN INSTALLATION OPENING
CADRE POUR RECEVOIR UN APPAREIL DANS UNE NICHE DE MONTAGE

(30) Priorität: 11.03.2009 DE 102009001457
(43) Veröffentlichungstag der Anmeldung: 18.01.2012
(73) Patentinhaber: Robert Bosch GmbH, 70442 Stuttgart (DE)
(72) Erfinder: ANDERS, Bernward, 31134 Hildesheim (DE)
(86) Internationale Anmeldenummer: PCT/EP2010/053100
(87) Internationale Veröffentlichungsnummer: WO 2010/103069

(56) Entgegenhaltungen:
- DE-A1- 2 903 176
- DE-A1-102007 004 021
- DE-U- 7 933 920

## Beschreibung

Die Erfindung betrifft einen Einbaurahmen zur Aufnahme eines Gerätes in einer vorgegebenen Einbauöffnung

### Stand der Technik

Aus DE 29 03 176 C2 ist eines Einbaueinrichtung zum Einbau eines Zusatzgeräts in eine vorgegebene Einbauöffnung, insbesondere einen genormten Einbauschacht in einem Kraftfahrzeug, beschrieben. Diese Einbaueinrichtung umfasst einen Einbaurahmen zur Aufnahme und Befestigung des Zusatzgeräts. Der Einbaurahmen weist Wandabschnitte auf, die einen im Wesentlichen quaderförmigen, zumindest vorderseitig offenen Hohlraum zur Aufnahme des Zusatzgeräts umschließen, wobei Vorderkanten zumindest eines Teils der Wandabschnitte flanschartig nach außen überstehende Randabschnitte zum Anliegen an einer Vorderkante der Einbauöffnung bilden. Weiter sind an die Waridabschnitte Rastmittel angeformt, die nach Deformierung aus den Wandabschnitten nach außen überstehen und die Einbauöffnung rückseitig hintergreifen. Somit ist der Einbaurahmen durch die vorderseitigen Randabschnitte und die bezüglich der Einbauöffnung rückseitigen Rastmittel an der Einbauöffnung verklemmt und damit befestigt.

Das Zusatzgerät kann dann in einem solchen Einbauschacht mit verschiedenen Mitteln, im Fall der DE 29 03 176 C2 mit am Gehäuse des Zusatzgeräts angeordneten, nach außen abstehenden Rastfedern, die beim Einschieben des Geräts in den Einbaurahmen Durchbrüche des Einbaurahmens durchdringen und deren Kanten hintergreifen, befestigt werden.

Ein solcher Einbaurahmen findet üblicherweise Verwendung, um ein Autoradio oder Fahrzeugnavigationssystem oder ein ähnliches Zusatzgerät in einem dafür vorgesehenen Ausschnitt eines Armaturenbretts eines Fahrzeugs zu installieren. Dieser Ausschnitt, auch Einbauschacht oder hier allgemeiner Einbauöffnung genannt, ist in der DIN/ISO 7736 beschrieben. Man spricht dort von dem 1 DIN Einbauraum, welcher die Maße 182 x 53 mm aufweist. Darüber hinaus gibt es, auch weitere Einbauschächte, die sich insbesondere in der Höhe unterscheiden, unter anderem beispielsweise den sogenannten 2DIN-Einbauschacht mit 112 mm Höhe.

Die aus DE 29 03 176 C2 bekannten Rahmen werden durch Biegen vorgestanzter Laschen formschlüssig mit dem Armaturenbrett, in der Folge auch als Dashboard bezeichnet, verbunden. Bei dieser Befestigungsmethode hat sich als nachteilig herausgestellt, dass im Falle eines Aufpralls von hinten keine sichere Verbindung gegeben ist. Bei der Wirksamkeit der bekannten Systemen kommt es darauf an, wie gut oder wie schlecht vorgestanzte Laschen gebogen werden und wie viele Laschen gebogen werden. Die Stabilität des Geräteeinbaus ist also davon abhängig, wie gewissenhaft diese Arbeiten ausgeführt werden. Weiter ist der Einbau durch das erforderliche Verbiegen der Laschen bzw. Rastmittel zeitaufwendig. Dies wiederum steht einer Montage in der Fahrzeugfertigung am Band entgegen.

Ein aus der DE 79 33 920 U bekannter Einbaurahmen weist zur Aufnahme eines Geärtes in einer vorgegebenen Einbauöffnung mit Wandabschnitten auf, die einen im Wesentlichen quaderförmigen, zumindest vorderseitig offenen Hohlraum zur Aufnahme des Gerätes umschließen. Die Vorderkanten der Wandabschnitte bilden nach außen überstehende Randabschnitte zum Anliegen an einer Vorderkante der Einbauöffnung. Es sind Rastmittel vorgesehen, die zumindest aus einem Teil der Wandabschnitte nach außen überstehen und die Einbauöffnung rückseitig hintergreifen, wobei die Rastmittel zumindest einen annähernd bogenförmigen Abschnitt aufweisen der in den Hohlraum hineinragt und weiterhin einen durch die Wandabschnitte hindurch nach außen überstehenden Endabschnitt zum Hintergriefen der Einbauöffnung aufweisen, derart, dass der bogenförmige Abschnitt bei Einsetzen eines Geräts in den Hohlraum eine Abflachung und infolge dessen eine Längung in Richtung der Rückseite der Einbauöffnung erfahren, so dass die Einbauöffnung zwischen vorderseitigen Randabschnitten und den Rastmitteln des Einbaurahmens geklemmt wird.

### Aufgabe der Erfindung

Es ist daher Aufgabe der vorliegenden Erfindung, einen solchen Einbraurahmen zu verbessern.

Diese Aufgabe wird mit einem Einbaurahmen mit den Merkmalen des unabhängigen Patentanspruchs gelöst.

### Vorteile der Erfindung

Die Erfindung mit den Merkmalen des unabhängigen Patentanspruchs hat den Vorteil, dass ein Einbaurahmen zur Aufnahme eines Geräts leicht und sicher in der Einbauöffnung befestigt werden kann. Die vorgeschlagene Lösung kommt mit wenig Montageaufwand aus. Der Einbau eines erfindungsgemäßen Einbaurahmens ist mit gegenüber bisherigen Lösungen geringeren Spezialkenntnissen oder -fertigkeiten und in geringerer Zeit möglich und eignet sich damit insbesondere auch für die Fließbandfertigung in der Kfz-Herstellung. Die Befestigung des Einbaurahmens ist gegenüber bisherigen Lösungen stabiler, insbesondere unempfindlicher gegenüber mechanischen Schocks, wie Schlägen oder Aufprall. Die Stabilität des Einbaus ist insbesondere auch weitgehend unabhängig von der Qualität der Arbeit des Monteurs.

Das zugrunde liegende Wirkprinzip beruht auf dem Längenverhältnis von Bogenmaß und Sehne eines Bogens. In die Aufnahmeöffnung des Einbauschachts ragende, einander gegenüberliegende sichel- oder bogenförmige Federarme werden beim Einschieben eines Zusatzgeräts, wie Autoradio, Navigationsgerät oder dergleichen so belastet, dass der Radius des Bogens vergrößert wird und sich in Folge dessen die Sehne des Bogens längt. Die Längung der Bogensehne führt zu einer form- und kraftschlüssigen Verbindung zwischen Halterahmen und Dashboard. Herstellungsbedingt können die Federarme auch als breites V mit großem Radius ausgefürt werden.

Bei der erfindungsgemäßen Ausführung dient als zusätzliches Mittel zur Aufanhem der durch die Federzunge ausgeübten Klemmkraft ein Freischnitt des Lagerpunktes in der Rahmenwand. Dieser Freischnitt wird hier durch zwei Schlitze bezogen auf die Einschubrichtung vor und hinter dem Lagerpunkt erreicht. Die Schlitze bewirken, dass der Lagersteg selbst zur Feder wird und damit einen Teil der Klemmkraft, die durch die Federzunge auf das Dashboard ausgeübt wird, aufnimmt. Diese Maßnahme dient somit als Überlastungsschutz. Die Erfindung setzt dabei keine gleiche Dashboard-Dicken voraus. Geringfügige Abweichungen der Materialstärke der Einbauwand werden durch die Federzungen an sich und/oder den federnden Lagersteg ausgeglichen.

### Zeichnungen

Ausführungsbeispiele der Erfindung sind in den Figuren dargestellt und werden nachfolgend näher erläutert. Gleiche Bezugszeichen in den Figuren bezeichnen dabei gleiche oder gleich wirkende Elemente
Figur 1 zeigt eine erste Variante des erfindungsgemäßen Einbaurahmens,
Figur 2 eine zweite Variante des erfindungsgemäßen Einbaurahmens,
Figur 3 eine Detailansicht des erfindungsgemäßen Einbaurahmens
Figur 4 eine Explosionszeichnung der Gesamtanordnung aus Einbauschacht, Einbaurahmen und einzubauendem Zusatzgerät
Figur 5 eine weitere Detailansicht des erfindungsgemäßen Einbaurahmens zusammen mit dem Einbauschacht
Figur 6 einen schematisierten Schnitt durch Einbauschacht, Einbaurahmen und einzubauendes Zusatzgerät zur Verdeutlichung der Wirkungsweise der Erfindung.

### Beschreibung der Ausführungsbeispiele

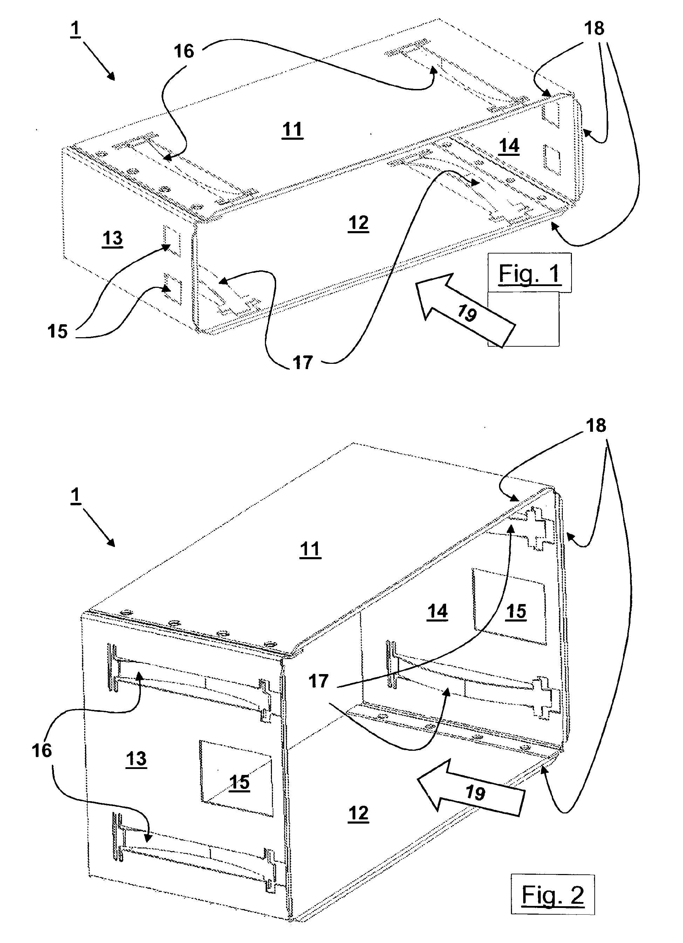

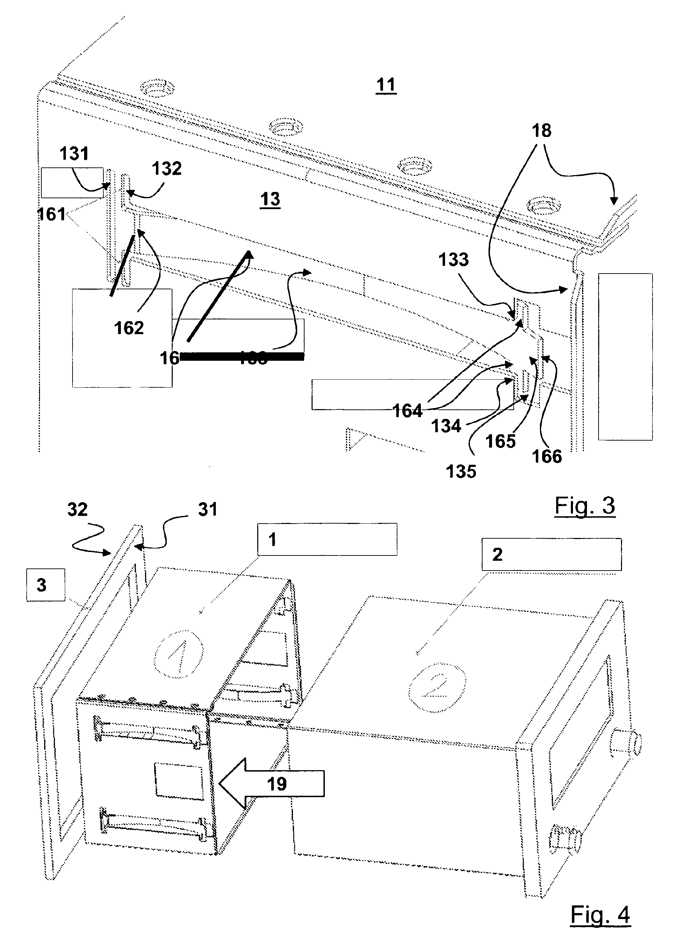

Figur 1 zeigt beispielhaft einen erfindungsgemäßen Einbaurahmen 1. Dieser Einbaurahmen 1 verfügt über einen Deckel 11, einen Boden 12 sowie über eine linke Seitenwand 13 und eine rechte Seitenwand 14. Deckel 11, Boden 12 und die beiden Seitenwände 13 und 14 umschließen einen im Wesentlichen quaderförmigen Raum, der der Aufnahme eines Gerät, beispielsweise eine Autoradio- oder Navigationsgeräts 2 (s. Figur 4) dient. Zur Aufnahme des Geräts 2 weist der Einbaurahmen 1 zumindest frontseitig eine Öffnung auf, in die das Gerät 2 entlang des Pfeils 19 eingeschoben werden kann. Vorzugsweise ist der Einbaurahmen 1 auch rückseitig offen, um beispielsweise Anschlussleitungen für das Gerät 2 leicht verlegen zu können.

Der Einbaurahmen 1 weist in seinen Seitenwänden 13 und 14 Öffnungen 15 auf. Diese dienen in an sich beispielsweise aus der eingangs erwähnten DE 29 03 176 C2 bekannter Weise der Befestigung des Geräts 2. Dazu weist das Gerät 2 an den Seitenwänden seines Gehäuses entsprechende Rastmittel auf, die bei Einschieben in den Einbaurahmen 1 entlang der Einschubrichtung 19 in der Endposition des Geräts 2 im Rahmen in die Öffnungen 15 einrasten und das Gerät 2 somit im Rahmen halten.

An seiner Vorderseite weist der Rahmen 1 einen Randabschnitt 18 auf, der über die äußeren Abmessungen des Rahmens 1 herausragt. Wird der Einbaurahmen 1 in einen von den äußeren Abmessungen passenden Einbauschacht oder allgemeiner in eine Einbauöffnung in einer Wandung, beispielsweise einem Dashboard eines Fahrzeugs, eingeschoben, liegt der Randabschnitt 18 frontseitig an der die Einbauöffnung umgebenden Wandung 31 an und sichert somit den Einbauschacht 1 gegen ein weiteres Verschieben in Einschubrichtung 19.

Soweit ist der Einbauschacht 1 aus der vorgenannten DE 29 03 176 C2 bekannt.

Der erfindungsgemäße Einbauschacht 1 weist nun in einander gegenüberliegenden Wänden, im vorliegenden Fall beispielsweise im Deckel 11 und im Boden 12, alternativ beispielsweise in den beiden Seitenwänden 13 und 14, Federzungen 16 und 17 auf. Diese Federzungen 16 und 17 sind einseitig im hinteren Bereich des Einbaurahmens mit der jeweils zugehörigen Wand, im vorliegenden Fall die Federzungen 16 mit dem Deckel 11, die Federzungen 17 mit dem Boden 12, verbunden (s. auch Figur 3). Ausgehend von dieser Lagerstelle 161 erstrecken sich die Federzungen 16 und 17, die sichel-, bogen oder V-förmig verformt und über eine Biegekante mit der Lagerstelle 161 verbunden sind, in Richtung der Einschuböffnung des Einbaurahmens 1. Dabei dringen die Federzungen 16 und 17 infolge ihrer Bogenform ausgehend von ihrem Lagerpunkt 161 (Figur 3) zunächst zunehmend in den Innenraum des Einbauschachts 1 ein um sich sodann wieder zunehmend den Wänden 11, 12 anzunähern. Im Fall der der abgebildeten Ausführungsform erstreckt sich dabei der bogenförmige Bereich 163 der Federzungen vom Lagerpunkt 161 bis im Wesentlichen zu deren freiem Ende.

Alternativ könnte der bogenförmige Bereich auch auf einen Teilbereich der Federzungen beschränkt sein. Weiter muss der bogenförmige Bereich auch nicht streng bogenförmig sein, vielmehr ist auch eine Annäherung eines Bogens durch beispielsweise aneinander gereihte gerade Abschnitte möglich.

Im vorderen Bereich der Wände 13 weisen diese Durchbrüche 135 auf, durch die Endabschnitte 165 der Federzungen 16 und 17 nach außen aus dem Einbaurahmen 1 herausragen. Die Federzungen 16 und 17 liegen dabei an rückseitigen Kanten 133 und 134 des Durchbruchs 135 an.

Der Einbaurahmen 1 gemäß Figur 2 unterscheidet sich von dem der Figur 1 durch seine Abmessungen und die Lage der Federzungen 16 und 17. Im Fall des Rahmens der Figur 1 handelt es sich um einen Rahmen für einen 1DIN-Einbauschacht, im Fall des Rahmens gemäß Figur 2 um einen solchen für einen demgegenüber höheren 2DIN-Schacht. Die Federzungen sind im ersten Fall in Deckel 11 und Boden 12, im Fall der Figur 2 in den Seitenwänden 13 und 14 angeordnet. Für die Funktion der Erfindung ist es vorteilhaft, wenn die Federzungen 16 und 17 in einander gegenüberliegenden Wänden angeordnet sind, also in Deckel und Boden oder in den beiden Seitenwänden.

Bei dem in den Figuren dargestellten Ausführungsbeispiel sind die Federzungen 16, 17 durch Scherung oder mit entspr. Freischnitten aus den entsprechenden Wänden 11, 12, 13 und/oder 14 herausgearbeitet, wobei im Zuge der Formung der Zungenkontur vorteilhaft auch die Bogenform eingeprägt wird. Die federnde Eigenschaft der Federzungen 16 und 17 ergibt sich aus der Verwendung von Federstahl-Blech, aber auch anderer elasischer Materialien für den Einbaurahmen 1, so dass auch die Federzungen 16 und 17 aus diesen Materialien gebildet werden.

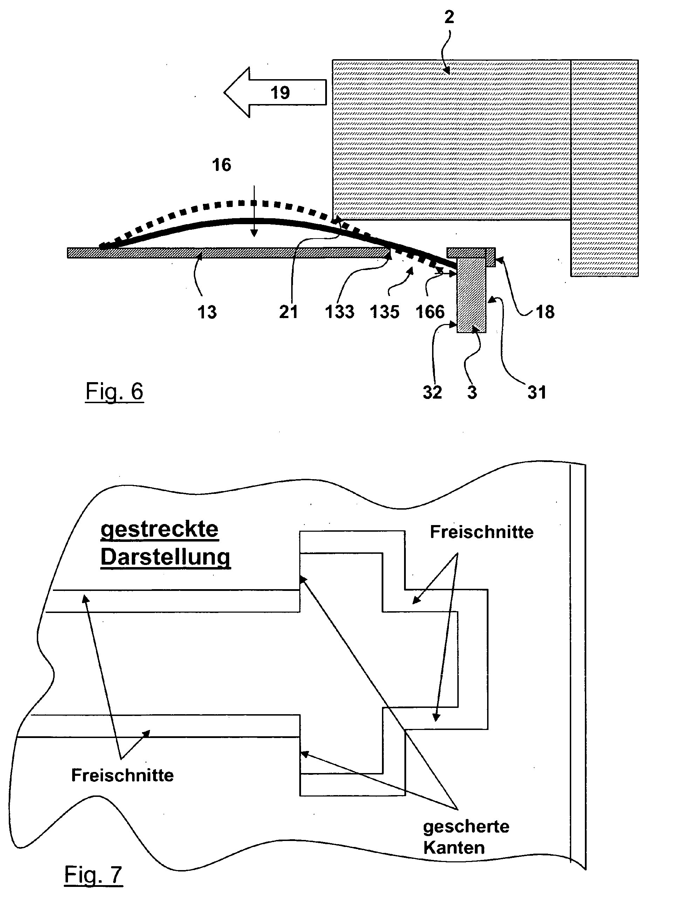

Zur Ausbildung des beschriebenen Widerlagers 133, 134 im vorderen Bereich des Einbauschachts 1 ist das Stanz-/Biege oder Scherwerkzeug derart ausgeformt, dass die Zunge 16 in ihrem freien vorderen Bereich Zapfen 164 erhält, welche sodann an den gescherten Kanten 133 und 134 des Durchbruchs 135 anliegen. Fig.7 Die Widerlager müssen nicht zwingend aus den gescherten Kanten der Wände entstehen, sondern können, je nach Werkzeugtechnologie auf eine andere Art entstehen. Beispielsweise durch bestimmte Biege-/Prägetechnologien oder separate Zusatzteile. Die Zapfen 164 können nicht durch den Durchbruch 135 hindurchrutschen, solange die Federzungen zumindest eine Mindestbiegung aufweisen. Erst bei vollständiger Streckung der Federzungen 16 und 17, also ohne Biegung, entspricht die Länge vom Lager 161 bis zur Kante 133, 134 des Durchbruchs 135 der Länge Lager 161 bis Hinterkante Zapfen 164 der Federzunge 16. Eine vollständige Streckung der Federzungen wird jedoch bei bestimmungsgemäßer Verwendung des Einbaurahmens 1 nicht erreicht. Im Ergebnis ragt somit lediglich ein Endabschnitt 165 der Federzungen 16 durch die Wand, hier 13, aus dem Einbaurahmen 1 heraus.

Das Zusammenwirkens des Einbaurahmens 1 mit Gerät 2 und dem Einbauschacht 3 wird im Folgenden unter anderem anhand der Explosionszeichnung der Gesamtanordnung (Figur 4) erläutert.

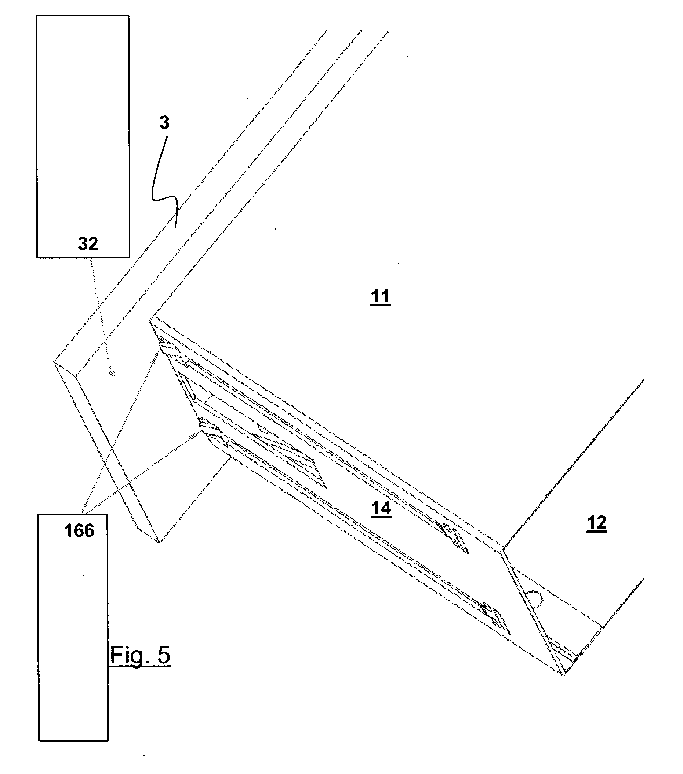

Zunächst wird der Einbauschacht 1 entlang der Einschubrichtung 19 durch die Öffnung des Dashboards 3 geschoben. Sobald die Endabschnitte 165 der Federzungen 16 und 17 die Vorderkante 31 der Einbauöffnung erreichen, weichen diese entgegen Federkraft in das Innere des Rahmens 1 zurück. Sobald die Endabschnitte 165 der Federzungen 16 und 17 bei weiterem Einschieben des Rahmens die Rückseite 32 des Dashboards erreichen, treten diese wieder infolge Federkraft durch die Durchbrüche 135 hindurch aus dem Einbaurahmen 1 heraus. In dieser Lage ist der Einbaurahmen 1 bereits gegen Herausrutschen aus dem Dashboard 3 gesichert, da nun die Endabschnitte 165, genauer die vorderseitigen Stirnflächen 166 der Endabschnitt 165 der Federzungen 16, das Dashboard 3 hintergreifen (s. Figur 5).

Im nächsten Arbeitsgang wird nun das Gerät 2, also beispielsweise Autoradio oder Fahrzeugnavigationsgerät 2 entlang Pfeilrichtung 19 in den Einbaurahmen 1 hineingeschoben (s. Figuren 4 und 6). Ab einer bestimmten Einschubtiefe gelangt eine Gehäusekante 21 des Geräts 2 in Anlage mit der ihr zugewandten Federzunge 16, die in das Innere des Einbauschachts 1 hineinragt. Gleiches gilt für eine der gegenüberliegenden Gehäusewand zugewandten Kante des Gerätegehäuses. Im Folgenden wird der Vorgang nur mit einer Gehäuseseite beschrieben, die erfolgt analog auch mit der gegenüberliegenden Gehäuseseite. Bei weiterer Verschiebung des Geräts 2 in Einschubrichtung 19 verdrängt die Gehäusekante 21 die Federzunge 16 entgegen Federkraft zunehmend in Richtung Seitenwand 13. Da die Federzunge infolge der Widerlagerung, im vorliegenden Beispiel wegen des Anliegens der Zapfen 164 an den Kanten 133 und 134, nicht frei durch die Wand 13 aus dem Innenraum des Einbaurahmens 1 ausweichen kann, vergrößert sich dabei der Radius des Bogens 163 der Federzunge 16. In der Folge verlängert sich die gedachte Sehne des Bogens, so dass das freie Ende 165 der Federzungen zunehmend durch den dafür vorgesehenen Durchbruch 135 der Wand 13 nach außen hindurch tritt. Im vorliegenden Fall entspricht dabei ein Federweg von 1 mm Abplattung des Bogens in Richtung auf die Gehäusewand 13 zu einer Verlängerung von rd.0,4 mm der Sehne. Bei einem Gesamtfederweg von beispielsweise 4 mm ergibt sich somit ein Klemmhub des freien Endes 165 der Federzungen von rd. 1,6 mm. Infolge dessen wird die Stirnseite 166 des freien Endes 165 der Federzunge 16 gegen die Rückseite 32 des Dashboards 3 gepresst. Somit ergibt sich eine form - und kraftschlüssige Verbindung zwischen Einbaurahmen 1 und Dashboard 3, welches zwischen Randabschnitt 18 des Einbaurahmens 1 und Stirnseite 166 der Federzunge(n) 16, 17 geklemmt wird.

Da das Dashboard 3 bzw. der die Einbauöffnung umgebende Rand häufig aus Kunststoff besteht, sollten die Federverhältnisse so ausgelegt werden, dass der Druck auf das Dashboard nicht übermäßig groß wird und das Ende 166 der Federzunge 16 sich nicht zu tief in das Material eingräbt.

Als zusätzliches Mittel zur Aufnahme der durch die Federzunge 16 ausgeübten Klemmkraft dient ein Freischnitt des Lagerpunktes 161 in der Rahmenwand. Dieser Freischnitt wird hier durch zwei Schlitze 132 und 133 bezogen auf die Einschubrichtung vor und hinter dem Lagerpunkt 161 erreicht. Die Schlitze 132 und 133 bewirken, dass der Lagersteg 161 selbst zur Feder wird und damit einen Teil der Klemmkraft, die durch die Federzunge 16 auf das Dashboard 3 ausgeübt wird, aufnimmt. Diese Maßnahme dient somit als Überlastungsschutz.

Der große Vorteil dieser Erfindung ist, dass das System äußerst variabel ist, solange das Grundkonzept von Bogenmaß und Sehne, sowie Federarm mit Gegenlager eingehalten wird. Es ist anwendbar für jede Einbauschachtgröße ob 1DIN, 2DIN oder jede Zwischengröße.

Die Erfindung setzt keine gleiche Dashboard-Dicken voraus. Geringfügige Abweichungen der Materialstärke der Einbauwand werden durch die Federzungen 16 an sich und/oder den federnden Lagersteg 161 ausgeglichen. Deutliche Abweichungen können vorzugsweise durch Anpassung der Länge des freien Federzungen-Endes 165, durch Änderung der Vorbiegung der Federzungen oder durch Anpassung der Federzungenlängen erreicht werden.

## Patentansprüche

1. Einbaurahmen (1) zur Aufnahme eines Geräts (2) in einer vorgegebenen Einbauöffnung (3), mit Wandabschnitten (11, 12, 13, 14), die einen im Wesentlichen quaderförmigen, zumindest vorderseitig offenen Hohlraum zur Aufnahme des Geräts (2) umschließen, wobei Vorderkanten zumindest eines Teils der Wandabschnitte (11, 12, 13, 14) flanschartig nach außen überstehende Randabschnitte (18) zum Anliegen an einer Vorderkante (31) der Einbauöffnung (30) bilden, und mit Rastmitteln (16, 17), die zumindest aus einem Teil der Wandabschnitte (11, 12, 13, 14) nach außen überstehen und die Einbauöffnung (3) rückseitig (32) hintergreifen, wobei die Rastmittel (16, 17) zumindest annähernd bogenförmige Abschnitte (163) aufweisen, die in den Hohlraum hineinragen und weiterhin einen durch die Wandabschnitte (11, 12, 13, 14) hindurch nach außen überstehenden Endabschnitt (165) zum Hintergreifen der Einbauöffnung (3) aufweisen, derart, dass die bogenförmigen Abschnitte (163) bei Einsetzen eines Geräts (2) in den Hohlraum eine Abflachung und infolge dessen eine Längung in Richtung der Rückseite (32) der Einbauöffnung (3) erfahren, so dass die Einbauöffnung (3) zwischen vorderseitigen Randabschnitten (18) und Rastmitteln (16, 17) des Einbaurahmens (1) geklemmt wird, **dadurch gekennzeichnet, dass** die Federzungen (16, 17) an ihrem dem freien Ende abgewandten Ende auf einem Federsteg (161) gelagert sind, und dass der Federsteg (161) durch Freischneiden des Lagerpunktes (161) aus einer Wandung (11, 12, 13, 14) des Einbaurahmens (1) gebildet ist.

2. Einbaurahmen nach Anspruch 1, **dadurch gekennzeichnet, dass** die Federzungen (16, 17) im Bereich des Wanddurchtritts (135) gelagert (133, 134, 164) sind.

3. Einbaurahmen nach Anspruch 2, **dadurch gekennzeichnet, dass** zur Lagerung der Federzungen (16, 17) im Bereich des Wanddurchtritts (135) an die Federzungen (16, 17) Zapfen (164) angeformt sind, die an korrespondierenden Kanten (133, 134) des Wanddurchtritts (135) der Wandabschnitte (11, 12, 13, 14) anliegen.

4. Einbaurahmen nach einem der vorhergehenden Ansprüche, **dadurch gekennzeichnet, dass** der Einbaurahmen aus Federstahl-Blech gefertigt ist.

## Claims

1. Installation frame (1) for accommodating a unit (2) in a predetermined installation opening (3), having wall portions (11, 12, 13, 14), which enclose an essentially cuboidal cavity which is open at least on the front side and is intended for accommodating the unit (2), wherein front edges at least of some of the wall portions (11, 12, 13, 14) form peripheral portions (18) which project outwards in a flange-like manner and are intended for butting against a front edge (31) of the installation opening (30), and having latching means (16, 17), which project outwards at least out of some of the wall portions (11, 12, 13, 14) and engage behind the installation opening (3) on the rear side (32), wherein the latching means (16, 17) have at least more or less arcuate portions (163), which project into the cavity, and also have an end portion (165) which projects outwards through the wall portions (11, 12, 13, 14), and is intended for engaging behind the installation opening (3), such that the arcuate portions (163), upon insertion of a unit (2) into the cavity, are flattened and, consequently, lengthened in the direction of the rear side (32) of the installation opening (3), and therefore the installation opening (3) is clamped between front-side peripheral portions (18) and latching means (16, 17) of the installation frame (1), **characterized in that**, at their end which is directed away from the free end, the resilient tongues (16, 17) are mounted on a resilient crosspiece (161), and **in that** the resilient crosspiece (161) is formed by virtue of the bearing point (161) being cut out of a wall (11, 12, 13, 14) of the installation frame (1).

2. Installation frame according to Claim 1, **characterized in that** the resilient tongues (16, 17) are mounted (133, 134, 164) in the region of the wall through-passage (135).

3. Installation frame according to Claim 2, **characterized in that**, for the purpose of mounting the resilient tongues (16, 17) in the region of the wall through-passage (135), stubs (164) are formed on the resilient tongues (16, 17), and these stubs butt against corresponding edges (133, 134) of the wall through-passage (135) of the wall portions (11, 12, 13, 14).

4. Installation frame according to one of the preceding claims, **characterized in that** the installation frame is produced from spring sheet steel.

## Revendications

1. Cadre de montage (1) pour recevoir un appareil (2) dans une ouverture de montage prédéfinie (3), comprenant des sections de paroi (11, 12, 13, 14) qui entourent un espace creux essentiellement rectangulaire ouvert au moins du côté avant pour recevoir l'appareil (2), des bords avant d'au moins une partie des sections de paroi (11, 12, 13, 14) formant des sections de bord (18) faisant saillie vers l'extérieur sous forme de rebord pour s'appliquer contre un bord avant (31) de l'ouverture de montage (30), et comprenant des moyens d'encliquetage (16, 17) qui font saillie vers l'extérieur au moins à partir d'une partie des sections de paroi (11, 12, 13, 14) et qui viennent en prise par l'arrière avec l'ouverture de montage (3) du côté arrière (32), les moyens d'encliquetage (16, 17) comprenant des sections (163) au moins approximativement en forme d'arc qui pénètrent dans l'espace creux et comprenant en outre une section d'extrémité (165) faisant saillie vers l'extérieur à travers les sections de paroi (11, 12, 13, 14) pour venir en prise par l'arrière avec l'ouverture de montage (3), de telle sorte que les sections (163) en forme d'arc subissent un aplatissement et par conséquent un allongement en direction de la face arrière (32) de l'ouverture de montage (3) lors de l'insertion d'un appareil (2) dans l'espace creux, de telle sorte que l'ouverture de montage (3) soit serrée entre les sections de bords avant (18) et les moyens d'encliquetage (16, 17) du cadre de montage (1), **caractérisé en ce que** les languettes élastiques (16, 17) sont montées sur une nervure élastique (161) à leur extrémité opposée à l'extrémité libre, et **en ce que** la nervure élastique (161) est formée par libération par découpage du point de montage (161) dans une paroi (11, 12, 13, 14) du cadre de montage (1).

2. Cadre de montage selon la revendication 1, **caractérisé en ce que** les languettes élastiques (16, 17) sont montées (133, 134, 164) dans la région du passage dans la paroi (135).

3. Cadre de montage selon la revendication 2, **caractérisé en ce que** des tourillons (164) sont formés sur les languettes élastiques (16, 17) pour le montage des languettes élastiques (16, 17) dans la région du passage dans la paroi (135), lesquels tourillons s'appliquent contre des bords correspondants (133, 134) du passage (135) dans les sections de paroi (11, 12, 13, 14).

4. Cadre de montage selon l'une quelconque des revendications précédentes, **caractérisé en ce que** le cadre de montage est fabriqué à partir de tôle en acier à ressorts.
